# EUROPÄISCHE PATENTSCHRIFT

(11) **EP 1 922 809 B1**
(45) Veröffentlichungstag und Bekanntmachung des Hinweises auf die Patenterteilung: **03.11.2010**
(21) Anmeldenummer: 06793323.4
(22) Anmeldetag: 07.09.2006
(51) Int. Cl.: G01N 29/02

(54) **VORRICHTUNG MIT PIEZOAKUSTISCHEM RESONATORELEMENT UND DEREN VERWENDUNG ZUR AUSGABE EINES SIGNALS IN ABHÄNGIGKEIT EINER RESONANZFREQUENZ**
DEVICE COMPRISING A PIEZOACOUSTIC RESONATOR ELEMENT AND ITS USE FOR OUTPUTTING A SIGNAL DEPENDING ON A RESONANT FREQUENCY
APPAREIL DOTE D'UN ELEMENT RESONATEUR PIEZOACOUSTIQUE ET SON UTILISATION POUR EMETTRE UN SIGNAL EN FONCTION D'UNE FREQUENCE DE RESONANCE

(30) Priorität: 09.09.2005 DE 102005043037
(43) Veröffentlichungstag der Anmeldung: 21.05.2008
(73) Patentinhaber: SIEMENS AKTIENGESELLSCHAFT, 80333 München (DE)
(72) Erfinder: GABL, Reinhard, A-8542 St. Peter im Sulmtal (AT); SCHREITER, Matthias, 81379 München (DE)
(86) Internationale Anmeldenummer: PCT/EP2006/066127
(87) Internationale Veröffentlichungsnummer: WO 2007/028817

(56) Entgegenhaltungen:
- US-A- 5 873 153
- US-A- 5 873 153
- LEE H-M ET AL: "THERMALLY DRIVEN THIN FILM BULK ACOUSTIC RESONATOR VOLTAGE CONTROLLED OSCILLATORS INTEGRATED WITH MICROHEATER ELEMENTS" JAPANESE JOURNAL OF APPLIED PHYSICS, JAPAN SOCIETY OF APPLIED PHYSICS, TOKYO, JP, Bd. 43, Nr. 1A/B, 15. Januar 2004 (2004-01-15), Seiten L85-L87, XP001192468 ISSN: 0021-4922
- FERRARI V ET AL: "Multisensor array of mass microbalances for chemical detection based on resonant piezo-layers of screen-printed PZT" SENSORS AND ACTUATORS B, ELSEVIER SEQUOIA S.A., LAUSANNE, CH, Bd. 68, Nr. 1-3, 25. August 2000 (2000-08-25), Seiten 81-87, XP004216596 ISSN: 0925-4005

## Beschreibung

Die Erfindung betrifft eine Vorrichtung umfassend mindestens ein piezoakustisches Resonatorelement mit einer piezoelektrischen Schicht und zwei an der piezoelektrischen Schicht anliegenden Elektroden, wobei das piezoakustische Resonatorelement derart beschaffen ist, dass durch Anlegen einer Wechselspannung an die piezoelektrische Schicht über die Elektroden eine Volumenschwingung der piezoelektrischen Schicht mit Resonanzfrequenz angeregt wird und eine Verwendung zur Ausgabe eines Signals in Abhängigkeit einer Resonanzfrequenz.

Piezoakustische Resonatorelemente dieses Typs, bei denen durch Anlegen eines Wechselspannungsfelds eine Dickenschwingung, d.h. eine Körpervolumenschwingung, der piezoelektrischen Schicht mit Resonanzfrequenz angeregt wird, sind unter der englischen Bezeichnung "Bulk Acoustic Wave (BAW) Piezoelectric Resonator" bekannt geworden und wurden in erster Linie für Hochfrequenzanwendungen der Kommunikationselektronik entwickelt.

Die einfachste Konfiguration zur Realisierung eines BAW-Resonators ist eine Schicht aus einem piezoelektrischen Material, das bei geeigneter kristallographischer Orientierung, z. B. mit der c-Achse senkrecht zur Elektrodenfläche, zwischen zwei Elektroden in Sandwichstruktur angeordnet ist.

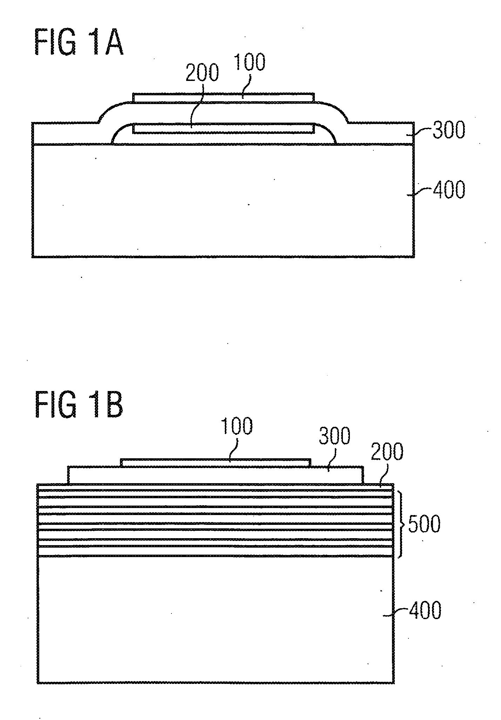

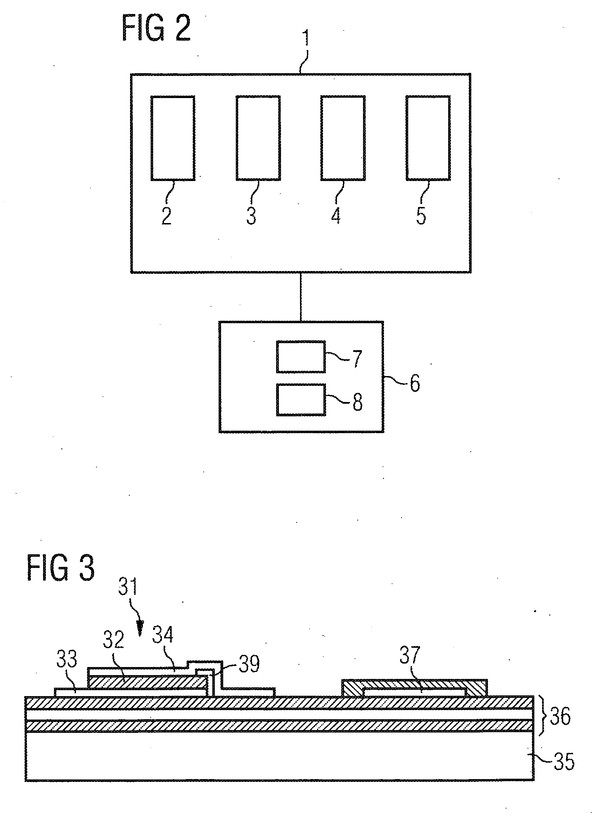

In den Figuren 1 und 2 sind zwei grundsätzliche Typen der BAW-Resonatoren schematisch dargestellt, wie sie in dem Übersichtsartikel von M. Dubois "Thin Film Bulk Acoustic Resonators: A Technology Overview", publiziert anlässlich der Tagung MEMSWAVE 03, Toulouse, France, July 2-4, 2003, gezeigt sind.

Figur 1A zeigt dabei ein Beispiel eines so genannten "Thin Film Bulk Acoustic Resonators (FBAR)" schematisch. Eine piezoelektrische AIN-Schicht 300 ist auf einem Trägersubstrat in Form eines Si-Wafers 400 aufgebracht. Auf der Unterseite und der Oberseite der piezoelektrischen Schicht sind. Elektroden 100 bzw. 200 angebracht. Wenn durch die Elektroden 100/200 ein elektrisches Wechselfeld an die piezoelektrische Schicht 300 angelegt wird, so tritt aufgrund des inversen piezoelektrischen Effekts eine Umwandlung der elektrischen Energie in mechanische Energie auf. Die resultierende akustische Volumenschwingung breitet sich innerhalb der piezoelektrischen Schicht aus, wobei die Fortschrittsrichtung parallel dem elektrischen Feld ist und die Welle an der Grenzfläche Elektrode/Luft reflektiert wird. Die Resonanzschwingung wird erreicht, wenn die Dicke des Schichtaufbaus des Resonators gleich der halben Wellenlänge des Eingangssignals beträgt. Zur Vermeidung akustischer Verluste in das Trägerssubstrat ist an der Unterseite der piezoelektrischen Schicht ein Hohlraum vorgesehen, sodass die akustischen Wellen an der Grenzfläche Elektrode/Luft reflektiert werden können.

Figur 1B zeigt einen Aufbau eines BAW-Resonators als so genannter Solidly Mounted Resonator (SMR). Im Unterschied zum Aufbau der Figur 1 ist hier zur Vermeidung akustischer Verluste in Richtung des Trägersubstrats ein akustischer Spiegel (Bragg-Reflektor) 500 zwischen der unteren Elektrode 300 und dem Substrat 400 vorgesehen. Dieser akustische Spiegel besteht aus mehreren Schichten mit stark unterschiedlicher akustischer Impedanz, die in wechselnder Folge angeordnet sind, beispielsweise Lagen von W/SiO₂ oder Al/AlN, etc. Die Schichtdicke beträgt λ/4.

Im Vergleich zu so genannten Oberflächenwellen-Resonatoren ("Surface Acoustic Wave-(SAW) Resonatoren), die bereits seit längerem als Filterelemente Anwendung in der Hochfrequenztechnik finden, besteht ein prinzipieller Unterschied darin, dass im Falle der BAW-Resonatoren eine Dickenschwingung (Volumenschwingung) der piezoelektrischen Schicht angeregt wird, im Gegensatz zu Oberflächenwellen bei Oberflächenwellen-Resonatoren. Die Anregung einer Volumenschwingung (Körpervolumenschwingung) erfolgt durch geeignete Elektrodenanordnung in Kombination mit geeigneter kristallographischer Orientierung der piezoelektrischen Schicht. Je nach Konfiguration kann es sich bei der angeregten Volumenschwingung des piezoakustischen Resonatorelements um eine longitudinale Schwingung oder eine Dickenscherschwingung handeln.

Dieser grundsätzliche Unterschied zwischen Oberflächenwellen-Resonatoren (SAW-Resonatoren) und Körpervolumenwellen-Resonatoren (BAW-Resonatoren) hat je nach Anwendungsgebiet erhebliche Auswirkungen auf die elektrischen Eigenschaften der Komponenten. Beispielsweise erfolgt bei der Anwendung von BAW Resonatoren als Filterelement im Hochfrequenzbereich aufgrund des zwischen den beiden Elektroden erzeugten elektrischen Felds nur eine minimale Kopplung mit elektrischen Feldern außerhalb der Metalloberflächen. Des Weiteren zeigen FBAR- bzw. BAW-Filter geringere elektrische Verluste im Durchlassbereich als OFW-Filter und sind darüber hinaus erheblich leistungsverträglicher als diese.

Besondere Vorteile ergeben sich auch in Bezug auf die Herstellungstechnologie, da sich BAW-Resonatoren in einfacher Weise mit Standard IC-Technologien (z. B. CMOS, BiC-MOS, etc.) auf einem Halbleiterchip als Trägersubstrat integrieren lassen.

Grundsätzlich kommen als Herstellungstechnologie für BAW-Resonatoren jedoch sowohl die Dickschichttechnik, die im Wesentlichen auf Siebdrucktechniken beruht und insbesondere für Strukturen im Bereich von >100 µm geeignet ist, als auch die Dünnschichttechnik, wie zum Beispiel die Abscheidung aus der Dampfphase über CVD-/PVD-Verfahren, in Betracht.

Auf Grund der Tatsache, dass über die Dünnschichttechnik Strukturen im Größenbereich deutlich unterhalb 10 µm bis hin in den sub-µm-Bereich zugänglich sind, bietet sich diese im Hinblick auf die Erfordernisse der zunehmenden Integration und der fortschreitenden Miniaturisierung der verschiedenen Komponenten besonders an.

Beispielsweise wird in der eingangs zitierten Veröffentlichung von Marc-Alexandre Dubois, Thin Film Bulk Acoustic Wave Resonators: A Technology Overview, MEMS Wave 03, Toulouse, France, July 2-4, 2003, als Herstellungstechnologie für BAW Resonatoren reaktives Sputtering als Herstellungsprozess zum Wachstum von Alüminiumnitridschichten als piezoelektrische Schicht auf entsprechenden Elektroden beschrieben. So lässt sich, wie in dieser Veröffentlichung beschrieben, durch reaktives Sputtering eine 1,8 µm dicke AlN-Schicht mit einem piezoelektrischen Koeffizienten von d_{33,f} von 5,3 ± 0,22 pm/V erzeugen, was auf die hohe Qualität der durch den Sputterprozess erzeugten AlN-Schicht hinweist.

Neben AlN können grundsätzlich z. B. auch ZnO, PZT (Bleizirkonattitanat) oder Lithiumniobat als piezoelektrische Schicht verwendet werden, wobei jedoch AlN im Hinblick auf seine chemischen, elektrischen und mechanischen Eigenschaften Vorteile aufweist, insbesondere aber auch was die bereits angesprochene Integration auf einem Halbleiter Chip anbetrifft.

Wie eingangs erwähnt, sind BAW-Resonatoren ursprünglich als passive Komponenten für die Hochfrequenztechnik insbesondere für Systeme im Zielbereich von 1 bis 10 GHz entwickelt worden. Als Anwendungsbeispiele sind insbesondere die Herstellung von spannungsgesteuerten Oszillatoren (Voltage Controlled Oscillator, VCO) oder von Verstärkern (Low Noise Amplifier, LNA) zu nennen.

Neben der Anwendung als Komponenten der Hochfrequenztechnik ist die Anwendung eines BAW-Resonators als Sensor vorgeschlagen worden. Beispielsweise beschreibt die Anmeldung WO 2004/017063 A2 der Anmelderin einen Sensor zur Erfassung der Anlagerung einer bestimmten Substanz an der Oberfläche des BAW-Resonators. Auf diese Weise lässt sich die betreffende Substanz identifizieren. Anlagerung kann dabei Adsorption und/oder Absorption bedeuten.

Strukturell weist der Resonator zu diesem Zweck eine sensitive Beschichtung auf, beispielsweise in Form eines Polymerfilms, die auf einer Elektrode des Resonators angebracht ist. Auf diesem Polymerfilm können verschiedene zu detektierende Substanzen, beispielsweise Kohlenwasserstoffe, absorbiert werden. Die zu detektierende Substanz liegt in einem Fluid (Gas oder Flüssigkeit) vor, das als Messmedium dient. Zur Messung wird der Sensor in Kontakt mit dem Messmedium gebracht, das die Substanz enthält, die sich an der sensitiven Beschichtung anlagern kann. Üblicherweise wird eine Mikrofluidik mit Messzelle verwendet, durch die das Messmedium über den betreffenden Oberflächenabschnitt des Sensors strömt.

Der Oberflächenabschnitt des Sensors, an dem sich die betreffende Substanz anlagert, richtet sich in vielen Fällen nach der Art der zu detektierenden Substanz, um auf diese Weise eine bestimmte Substanz selektiv aus einem Gemisch mehrerer Substanzen detektieren zu können. Beispielsweise beschreibt die oben genannte Patentanmeldung die Detektion von DNA-Fragmenten mittels eines Sensors, der auf einem Oberflächenabschnitt der Elektrode eine Beschichtung mit einer ausgewählten DNA-Sequenz aufweist, die eine Anlagerung passender DNA-Sequenzen nach dem Schlüssel-Schloss-Prinzip ermöglicht.

Bei der Detektion von DNA ist es entscheidend, das Stränge mit ein- oder mehrbasigen Mismatches gegenüber einem perfekten Match (komplementärer Strang) unterschieden werden können. Dies hängt in entscheidender Weise von dem Gleichgewichtszustand der Desorption der DNA-Stränge an dem Oberflächenabschnitt ab. Dieser Gleichgewichtszustand der Desorption wird von den Gegebenheiten des entsprechenden Systems, wie zum Beispiel Art der Beschichtung, Konzentration der beteiligten Spezies, Temperatur, etc. bestimmt.

Durch die Anlagerung einer Substanz an dem Resonator ändert sich die Resonanzfrequenz in Abhängigkeit der Masse der angelagerten Substanz. Durch Messung der Resonanzfrequenz kann daher auf die Anlagerung einer Substanz rückgeschlossen werden. Der betreffende Kennwert ist die Massensensitivität des Resonators, die proportional zum Quadrat der Resonanzfrequenz des Resonators ist.

In der genannten Patentanmeldung wird der positive Einfluss einer äußerst geringen Schichtdicke der piezoelektrischen Schicht im Bereich von 0,1 µm bis 20 µm beschrieben, was sich aufgrund des angesprochenen Zusammenhangs zwischen Massensensitivität und Resonanzfrequenz positiv auf die Detektionsempfindlichkeit des Sensors auswirkt. Zudem ergeben sich Vorteile im Hinblick auf Integrationsdichte und Miniaturisierung, insbesondere bei Sensor-Arrays, die mehrere derartige Sensorelemente enthalten.

Da die Resonanzfrequenz des piezoakustischen Resonators in gewissen Grenzen temperaturabhängig ist, kann das von einem Filter oder Sensor mit BAW-Resonator ausgegebene Signal einer ungewünschten Temperaturabhängigkeit unterliegen. Zur Lösung dieses Problems ist vorgeschlagen worden, verschiedene Materialien mit einem positiven bzw. negativen Temperaturkoeffizienten in Form eines Komposits zu verwenden, um auf diesem Wege die Temperaturdrift durch Kompensation abzugleichen. Dieser Lösungsansatz wird beispielsweise in der Veröffentlichung von K. M. Lakin, K. T. McCarron, J. F. McDonald and J. Belsick, "Temperature Coefficient and Aging of BAW Composit Materials", 2001, Frequency Control Symp. Proc., S. 605-608 beschrieben.

In der Veröffentlichung K. M. Lakin, Thin Film Resonator Technology, IEEE 2003, FCS-IFTF Paper We1A, May 5-8, 2003 wird ein in Bezug auf den Temperaturgang kompensierter Resonator beschrieben, bei dem AlN als piezoelektrische Schicht und SiO₂ zur Kompensation verwendet wird. Aufgrund des positiven Temperaturkoeffizienten von SiO₂ von +85 ppm/°C im Verhältnis zu -25 ppm/°C von AlN lässt sich durch sukzessive Erhöhung des Anteils an SiO₂ eine Kompensation der Temperaturdrift erzielen.

Jedoch ist dieser Lösungsansatz mit inhärenten Nachteilen behaftet, da er Beschränkungen in Bezug auf die Zusammensetzung der zu verwendenden Materialien oder den Gesamtaufbau des Elementes mit sich bringt.

In der Veröffentlichung: FERRARI V ET AL: "Multisensor array of mass microbalances for chemical detection based on resonant piezo-layers of screen-printed PZT" SENSORS AND ACTUATORS B, ELSEVIER SEQUOIA S.A., LAUSANNE, CH, Bd. 68, Nr. 1-3, 25. August 2000 (2000-08-25), Seiten 81-87, wird eine Vorrichtung gemäß Fig. 1 und Fig. 3 beschrieben, die einen in der Dickschichttechnik ausgebildeten PZT Resonator umfasst (BAW Resonatorelement abgebildet in Figs 1 bzw. als Sensorarray in Fig. 3), wobei der Resonator als Sensor zur Detektierung einer Substanz verwendet wird und wobei die Vorrichtung mit einer Temperaturerfassungseinrichtung ausgestattet ist.

Aufgabe der Erfindung ist es, eine verbesserte Vorrichtung umfassend mindestens ein piezoakustisches Resonatorelement der eingangs genannten Art, die das Problem der Temperaturabhängigkeit der Resonanzfrequenz löst. Insbesondere ist eine Aufgabe der vorliegenden Erfindung eine derartige Vorrichtung, die als Sensor zur Detektion einer Substanz ausgestaltet ist, mit erhöhter Messgenauigkeit und erweitertem Einsatzbereich bereitzustellen.

Darüber hinaus ist es eine Aufgabe der Erfindung, ein optimiertes Verfahren zur Ausgabe eines Signals in Abhängigkeit einer Resonanzfrequenz eines piezoakustischen Resonators anzugeben.

Diese Aufgabe wird durch eine Vorrichtung mit piezoakustischem Resonatorelement mit den Merkmalen des Anspruchs 1 bzw. durch die Verwendung zur Ausgabe eines Signals in Abhängigkeit einer Resonanzfrequenz eines piezoakustischen Resonators gemäß Anspruch 10 angegeben.

Erfindungsgemäß ist eine integriert mit dem piezoakustischen Resonatörelement ausgebildete Temperaturerfassungseinrichtung (3)vorgesehen, die der Erfassung der Arbeitstemperatur der Vorrichtung dient.

Die Arbeitstemperatur der Vorrichtung im Sinne der vorliegenden Erfindung kann die Temperatur des piezoakustischen Resonatorelements sein. Die Erfindung ist jedoch nicht hierauf beschränkt. Der Ort der Arbeitstemperatur der Vorrichtung kann ein beliebiger Abschnitt der Vorrichtung selbst und/oder ein Umgebungsabschnitt nahe der Vorrichtung sein.

Insbesondere bei Ausgestaltung der Vorrichtung als Sensor zur Detektion einer Substanz kann sich die Arbeitstemperatur auf den Oberflächenabschnitt beziehen, an dem sich die zu detektierende Substanz anlagert. Auch die Temperatur des Messmediums, in dem sich die Substanz befindet, kann eine Arbeitstemperatur der Vorrichtung im Sinne der vorliegenden Erfindung darstellen.

Zur Integration der Temperaturerfassungseinrichtung mit dem piezoakustischen Resonatorelement ist das Messelement der Temperaturerfassungseinrichtung vorteilhafterweise als Schicht ausgebildet. Bei einer bevorzugten Ausführungsform kann die Schicht im Wesentlichen aus einem Material bestehen, das als Widerstandsheizer auch zum Beheizen der Vorrichtung ausgebildet sein kann.

Die Schichtdicke des Temperaturelements liegt im Bereich unterhalb 25 µm, besonders bevorzugt beträgt die Schichtdicke < 10 µm, und am meisten bevorzugt wird eine Schichtdicke < 1 µm. Eine geringe Schichtdicke begünstigt die Integration des Heizelementes mit dem piezoakustischen Resonatorelement durch Nutzung von Verfahren der Dünnschichttechnologie, wie zum Beispiel Abscheideverfahren über PVD/CVD-Prozesse. Hierdurch wird es in besonders einfacher Weise ermöglicht, die Temperaturerfassungseinrichtung gemeinsam mit dem in Schichttechnik ausgebildeten piezoakustischen Resonatorelement zu prozessieren.

Bei der erfindungsgemäßen Vorrichtung ist die als Schicht ausgebildete Temperaturerfassungseinrichtung gemeinsam mit dem piezoakustischen Resonatorelement auf einem Trägersubstrat ausgebildet, bei dem es sich um ein Halbleitersubstrat handeln kann.

Dabei können zwischen dem schichtförmigen Messelement und dem Trägersubstrat Zwischenschichten angeordnet sein. Bei der erfindungsgemäßen Vorrichtung das piezoakustische Resonatorelement und das Messelement in Schichttechnik auf Zwischenschichten angeordnet sein, die als akustischer Spiegel (Bragg-Reflektor) fungieren, der einen akustischen Verlust in Richtung des Substrats reduzieren soll.

Neben dem Messelement kann die Temperaturerfassungseinrichtung übliche Funktionselemente wie z.B. Verbindungsmittel mit einer externen Spannungsversorgung umfassen.

Vorzugsweise beträgt der Abstand zwischen dem Messelement und der piezoelektrischen Schicht des piezoakustischen Resonators weniger als 250 µm, stärker bevorzugt weniger 150 µm und am meisten bevorzugt weniger als 50 µm. Dies ergibt eine geringe Temperaturabweichung im Bereich weniger Zehntel Kelvin oder geringer.

Grundsätzlich kann erfindungsgemäß eine Elektrode des piezoakustischen Resonatorelements selbst als Temperaturmesselement fungieren.

Eine verbesserte Integrationsmöglichkeit und Miniaturisierung ergibt sich jedoch bei Verwendung von z.B. aus der Halbleitertechnik bekannten Dünnschichttechnologien zur Herstellung von Schichtdicken im sub-µm-Bereich bis hin in den nm-Bereich. Hierbei kann es sich um übliche PVD/CVD-Verfahren handeln.

Was die Materialbeschaffenheit des Messelementes anbetrifft, wird vorzugsweise ein Material verwendet, das als Metallwiderstandsthermometer fungieren kann. In diesem Fall kann das Messelement auch als Heizelement betrieben werden, bei dem die Vorrichtung nicht nur dazu eingerichtet wird, aus dem Widerstandswert des Temperaturmesselements die Temperatur zu ermitteln, sondern auch durch Aufheizen die Temperatur der Vorrichtung zu steuern. In diesem Zusammenhang ist insbesondere Platin zu nennen, dessen Temperaturkoeffizient des Widerstands von 3,85·10⁻³/°C beträgt, bei einem Einsatzbereich von -200 bis +850 °C. Auch Nickel kann verwendet werden, wenn die zu messende Temperatur 150 °C nicht überschreitet. Nickel bietet insbesondere im Hinblick auf den geringeren Preis Vorteile gegenüber Platin.

Durch die Ausgestaltung der Vorrichtung mit Temperaturerfassungseinrichtung (Mikrosensor) und Heizeinrichtung in einem Bauteil wird eine geschlossene Temperaturregelung der Arbeitstemperatur des piezoakustischen Resonatorelements ermöglicht, die die Steuerung der Temperatur durch die Heizeinrichtung, die Erfassung der erzielten Arbeitstemperatur durch die Temperaturerfassungseinrichtung und die sich anschließende Regelung der Arbeitstemperatur in Abhängigkeit der erfassten Temperatur umfasst.

Auf diese Weise kann beispielsweise eine effektive Temperaturkompensation der Resonanzfrequenz vorgenommen werden, indem sichergestellt wird, dass die Vorrichtung bei einer vorgegebenen Temperatur betrieben wird.

Die erfindungsgemäße Vorrichtung, in der ein Temperatursensor integriert mit dem piezoakustischen Resonatorelement ausgebildet ist, kann eine Auswerteeinrichtung mit einer Speichereinrichtung umfassen, in der die entsprechende Kennlinie der Temperaturabhängigkeit des Widerstands für das gegebene Material abgelegt ist, und einer Ausleseeinrichtung zum Auslesen eines Temperaturwerts in Abhängigkeit des erfassten Widerstandswerts. Auswerteeinrichtung mit Ausleseeinrichtung können Bestandteil einer externen Einrichtung sein, die in geeigneter Weise mit der Temperaturerfassungseinrichtung elektrisch verbunden ist. Elektrisch verbunden im Sinne der vorliegenden Erfindung kann auch eine übliche Wireless-Verbindung sein und ist nicht auf konventionelle Verdrahtung beschränkt.

Bei einer Ausführungsform sind die für die Auswerteeinrichtung notwendigen elektronischen Komponenten mit in das Trägersubstrat des piezoakustische Resonatorelements integriert, um die Integrationsdichte weiter zu steigern. Entsprechende Verfahren und die dafür benötigten Technologien sind aus dem Bereich der Integration elektronischer Komponenten grundsätzlich bekannt. Die Auswerteeinrichtung kann jedoch auch als externe Vorrichtung ausgeführt sein.

Neben einer derartigen Auswerteeinrichtung zur Bestimmung der Temperatur aus dem von der Temperaturerfassungseinrichtung bereitgestellten Messwert kann eine weitere Auswerteeinrichtung zur Bestimmung der Resonanzfrequenz des Resonators in dem piezoakustischen Resonatorelement integriert sein. Hierbei kann es sich beispielsweise um einen Hochfrequenzschaltkreis handeln, in dem der Resonator die Frequenz bestimmt. Eine derartige Auswerteeinrichtung zur Ermittlung der Resonanzfrequenz lässt sich in bekannter Weise beispielsweise über CMOS-, Bipolar- oder BIC-MOS Technologie in einem Halbleitersubstrat integrieren.

Die Vorrichtung kann zudem eine Korrektureinrichtung zur Korrektur des Ausgangssignals des piezoakustischen Resonatorelements in Abhängigkeit der ermittelten Temperatur umfassen. Zu diesem Zweck kann in der entsprechenden Vorrichtung der Temperaturgang der Resonanzfrequenz des piezoakustischen Resonatorelements als Kennlinie hinterlegt sein. Auch bei der Korrektureinrichtung kann es sich um eine integrierte oder eine externe Komponente handeln.

Gemäß Anspruch 1 ergibt sich für die Ausgestaltung der erfindungsgemäßen Vorrichtung als Sensor zur Detektion einer Substanz, da durch Steuerung der Temperatur die Gleichgewichtsbedingungen der Anlagerung der zu detektierenden Substanz an dem Oberflächenabschnitt des piezoakustischen Resonatorelements gezielt gesteuert werden können. Auf diese Weise kann je nach zu detektierender Substanz die Genauigkeit der Messwerterfassung erhöht werden. Gleichzeitig kann der Einsatzbereich des Sensors vergrößert werden, da die Sorptionbedingungen, die neben der Temperatur durch das Messmedium (Gas, Flüssigkeit), durch die zu detektierende Substanz, sowie weitere gegebenenfalls in dem Messmedium befindliche Substanzen bestimmt werden, gezielt eingestellt werden können. Auf diese Weise wird die Detektion von Substanzen zugänglich, die sich beispielsweise nur bei einer vorgegebenen Temperatur an dem Oberflächenabschnitt des Sensors anlagern. "Detektion einer Substanz", im Sinne der vorliegenden Erfindung kann dabei der Identifikation einer Substanz dienen. Der Sensor kann aber auch als Massensensor zur Ermittlung einer angelagerten Menge ausgebildet sein.

Bei der erfindungsgemäßen Vorrichtung als Sensor zur Detektion einer Substanz kann es vorteilhaft sein, dass sich die Temperaturerfassungseinrichtung an einer Position des Sensorelementes befindet, die gewährleistet, dass sich das Messelement in Kontakt mit dem Messmedium befindet. Hierdurch kann z.B. auch eine Erwärmung des Messmediums, das beispielsweise durch eine Flusszelle des Sensors strömt, erfasst werden.

Die Erfindung umfasst ferner die Verwendung zur Ausgabe eines Signals, das von einer Resonanzfrequenz abhängt, mit den Schritten Erfassen der Arbeitstemperatur eines piezoakustischen Resonatorelements einer Vorrichtung umfassend mindestens ein piezoakustisches Resonatorelement mit einer piezoelektrischen Schicht und zwei mit der piezoelektrischen Schicht elektrisch kontaktierten Elektroden, wobei das piezoakustische Resonatorelement derart beschaffen ist, dass durch Anlegen einer Wechselspannung an die piezoelektrische Schicht über die Elektroden eine akustische Volumenschwingung der piezoelektrischen Schicht mit einer Resonanzfrequenz angeregt wird, durch ein Messelement, Anregen einer Volumenschwingung der piezoelektrischen Schicht des piezoakustischen Resonatorelements mit Resonanzfrequenz, und Ausgeben eines Ausgabesignals in Abhängigkeit der gemessenen Temperatur.

Bei einem besonders vorteilhaften Ausführungsbeispiel des erfindungsgemäßen Verfahrens handelt es sich um ein Verfahren zur Detektion einer Substanz, das vorzugsweise unter Verwendung der erfindungsgemäßen Vorrichtung erfolgt. Dieses Verfahren beinhaltet die Schritte Zusammenbringen des Fluids und des piezoakustischen Resonators derart, dass die Substanz an einem Abschnitt des Resonators absobiert und/oder adsobiert werden kann, und Bestimmen einer Resonanzfrequenz des Resonators, wobei aus der Resonanzfrequenz auf die an dem Oberflächenabschnitt angelagerte Menge der Substanz geschlossen werden kann. Bei dem erfindungsgemäßen Verfahren wird vor dem Schritt des Bestimmens der Resonanzfrequenz eine Erfassung der Arbeitstemperatur der Vorrichtung mit dem piezoakustische Resonatorelement vorgenommen.

Bei dem erfindungsgemäßen Verfahren wird zusätzlich die Arbeitstemperatur der Vorrichtung mit einem entsprechenden piezoakustischem Resonatorelement gesteuert werden. Dies erfolgt in besonders einfacher Weise durch die oben beschriebene Vorrichtung, bei der gleichzeitig ein Temperaturmesselement und ein Heizelement in der Vorrichtung integriert sind. Das Verfahren kann dabei den Schritt des Regelns der Arbeitstemperatur, d.h. die Steuerung in Abhängigkeit der gemessenen Temperatur, beinhalten.

Auf diese Weise kann je nach zu detektierender Substanz die Genauigkeit des Sensors erheblich erhöht werden. Außerdem ermöglicht es das Verfahren, bestimmte Substanzen, die beispielsweise bei Raumtemperatur nicht detektiert werden können, zu erfassen.

Die vorliegende Erfindung ergibt insbesondere die folgenden Vorteile:
- Durch geringen Mehraufwand und Prozessierung kann mit dem Messelement ein weiteres notwendiges Element auf dem Trägersubstrat (Chip) integriert werden.
- Dies trägt insbesondere bei stark miniaturisierten System vor allem der Integration Rechnung.
- Im Gegensatz zu einer diskreten Lösung kann das Messelement sehr nahe an den piezoakustischen Resonator herangeführt werden, so dass eine entsprechende Messgenauigkeit resultiert.
- Insbesondere bei der Verwendung von Platin kann gleichzeitig ein Heizelement bereitgestellt werden. Hierdurch wird eine vollständige Temperaturregelung ermöglicht.
- Durch Erfassen der Arbeitstemperatur des piezoakustischen Resonatorelements kann dem Temperaturgang der Resonanzfrequenz Rechnung getragen werden.

Die Erfindung schafft piezoakustische Resonatoren, die einfach aufgebaut sind und gegenüber den bisher bekannten BAW-Resonatoren Ausgangssignale liefern, die in Bezug auf das Hintergrundsignal, das aus der Temperaturänderung der Einrichtung resultiert, vollständig diskriminiert sind. Die hierfür notwendige Temperaturinformation in unmittelbarer Nähe des Resonatorelements unter Arbeitsbedingungen wird durch die Temperaturerfassungseinrichtung bereitgestellt, die in unmittelbarer Nähe des Resonatorelements angeordnet ist. Dies wird durch Integration des piezoakustischen Resonatorelements mit der Temperaturerfassungseinrichtung realisiert unter Ausnutzung grundsätzlich bekannter Technologien, wie sie beispielsweise aus der Dünnschichttechnik und/oder der Dickschichttechnik bekannt sind, realisiert.

Auf diese Weise kann eine kostengünstige Vorrichtung umfassend ein piezoakustisches Resonatorelement bereitgestellt werden, die beispielsweise als Filterelement für HF-Anwendungen, als Sensor (Biosensor) oder als Aktorelement (Mischen, Pumpen) Verwendung finden kann. Neben dem piezoakustischen Resonatorelement mit der Temperaturerfassungseinrichtung kann die erfindungsgemäße Vorrichtung diverse Auswerteeinrichtungen zur Ermittlung der Temperatur aus dem von der Temperaturerfassungseinrichtung gelieferten Messwert und/oder einer Auswerteeinrichtung zur Bestimmung einer Resonanzfrequenz umfassen. Zusätzlich kann eine Korrektureinrichtung vorgesehen sein, die es ermöglicht, anhand einer vorgegebenen Charakteristik eine Korrektur des Ausgangswerts der Vorrichtung in Bezug auf die in der jeweiligen Arbeitssituation gegebene Temperatur vorzunehmen. Auf diese Weise kann die Genauigkeit der Vorrichtung gegenüber herkömmlich bekannten Vorrichtungen dieser Art erheblich verbessert werden.

Vorteilhafte Ausgestaltungen und weitere Details der vorliegenden Erfindung werden im Folgenden anhand verschiedener Ausführungsbeispiele mit Bezug auf die Figuren beschrieben.
- Fig. 1A: und B zeigen schematisch den Aufbau eines FBAR- und eines SMR-Resonators als Beispiele für BAW- Resonatoren, die aus dem Stand der Technik bekannt sind, im Querschnitt.
- Fig. 2: zeigt schematisch den Aufbau eines ersten Ausführungsbeispiels einer erfindungsgemäßen Vorrichtung.
- Fig. 3: zeigt eine Ausführungsform eines piezoakustischen Resonatorenelements und einer Temperaturerfassungseinrichtung, die auf einem Trägersubstrat integriert sind, im Querschnitt.
- Fig. 4: zeigt ein Ablaufdiagram eines Ausführungsbeispiels eines Verfahrens zur Herstellung der erfindungsgemäßen Vorrichtung.
- Fig. 5: zeigt ein Ablaufdiagram eines Ausführungsbeispiels eines erfindungsgemäßen Verfahrens zur Ausgabe eines Signalwertes, der von einer Resonanzfrequenz abhängt.

Fig. 2 zeigt den schematischen Aufbau eines Ausführungsbeispiels der erfindungsgemäßen Vorrichtung. Demnach umfasst die erfindungsgemäße Vorrichtung 1 ein piezoakustisches Resonatorelement 2, eine Temperaturerfassungseinrichtung 3, eine Auswerteeinrichtung 4 zur Ermittlung der Resonanzfrequenz des piezoakustischen Resonatorelements 2 und eine Auswerteeinrichtung 5 zur Ermittlung der Temperatur aus einem Messwert, der von der Temperaturerfassungseinrichtung 3 bereitgestellt wird. Im vorliegenden Ausführungsbeispiel handelt es sich hierbei um den Widerstand der Temperaturerfassungseinrichtung 3. Die Erfindung ist jedoch nicht hierauf beschränkt. Vielmehr können beliebige aus der Technik bekannte Temperaturmessfühler oder ähnliche Einrichtungen zur Messung der Temperatur verwendet werden, soweit sie verfahrenstechnisch mit dem piezoakustischen Resonatorelement integrierbar sind.

Während beim Ausführungsbeispiel der Fig. 2 die Auswerteeinrichtung 4 zur Ermittlung der Resonanzfrequenz als in die Vorrichtung 1 integriert gezeigt wurde, ist die Erfindung nicht auf diese Ausführungsform beschränkt. Vielmehr kann die Auswerteeinrichtung zur Ermittlung der Resonanzfrequenz auch als externe Vorrichtung vorgesehen sein, mit der die Vorrichtung 1 elektrisch verbunden ist. Auch die Auswerteeinrichtung 5 zur Ermittlung der Temperatur kann, obgleich sie beim vorliegenden Ausführungsbeispiel als integraler Bestandteil der Vorrichtung 1 gezeigt ist, extern vorgesehen sein.

Beispielsweise kann bei einer einfachen und zweckmäßigen Ausgestaltung der erfindungsgemäßen Vorrichtung die Auswerteeinrichtung 5 zur Ermittlung der Temperatur als externe Speichereinrichtung vorgesehen sein, in der der Temperaturgang des Widerstandes der Temperaturerfassungseinrichtung 3 gespeichert ist. Aus dem Widerstandswert der Temperaturerfassungseinrichtung kann anhand dieser Einrichtung dann auf die Temperatur rückgeschlossen werden.

Die grundsätzlichen Komponenten beider Auswerteeinrichtungen 4 und 5 richten sich nach dem jeweiligen Anwendungsfall (Frequenz, Temperatur, etc.) und sind als Elektronikkomponenten an sich bekannt.

Die Vorrichtung 1 ist mit einer Vorrichtung 6 zur Korrektur der Resonanzfrequenz in Abhängigkeit der ermittelten Temperatur verbunden. Die Korrekturvorrichtung 6 ist als externe Vorrichtung ausgeführt und umfasst ein Speicherelement 7, in dem der Temperaturgang der Resonanzfrequenz abgespeichert ist. Des Weiteren umfasst die Korrekturvorrichtung 6 eine Einrichtung 8 zur Korrektur der Resonanzfrequenz anhand der in dem Speicherelement 7 gespeicherten Werte. Die Korrektureinrichtung 8 ist dazu eingerichtet, diese korrigierte Resonanzfrequenz als Ausgabewert auszugeben.

Fig. 3 zeigt den schematischen Aufbau einer erfindungsgemäßen Vorrichtung 30, bei der ein piezoakustisches Resonatorelement und ein Temperatursensor miteinander integriert auf einem Trägersubstrat ausgebildet sind. Der piezoakustische Resonator 31 umfasst eine aus ZnO bestehende piezoelektrische Schicht 32, eine erste Platinelektrode 33 an seiner Unterseite und eine zweite Platinelektrode 34 an seiner Oberseite. Die untere Platinelektrode 33 ist auf einem Siliziumträgersubstrat 35 aufgebracht. Zwischen dem piezoakustischen Resonatorelement 31 und dem Trägersubstrat 35 ist ein akustischer Spiegel 36 vorgesehen, der akustische Verluste in Richtung des Substrats 35 verhindern soll.

Die Dicke der Pt-Elektroden 33, 34 liegt im Bereich von 250 nm. Die Dicke der piezoelektrischen Schicht (ZnO) beträgt 400 nm. Die Herstellung des gezeigten Arrays der Fig. 3 erfolgte über fotolithografische Verfahren zur Strukturierung eines platinbeschichteten Si-Wafers.

Zusammen mit dem piezoakustischen Resonator 31 ist auf dem Halbleitersubstrat 35 eine Temperaturerfassungseinrichtung aufgebracht. Die Temperaturerfassungseinrichtung weist eine Schicht 37 aus Platin mit einer Schichtdicke 1 µm auf, die als Messelement der Temperaturerfassungseinrichtung dient. Die Platinschicht 37 ist durch die Isolation 38, die aus Al₂O₃ besteht, gegenüber dem piezoakustischen Resonator 31 isoliert.

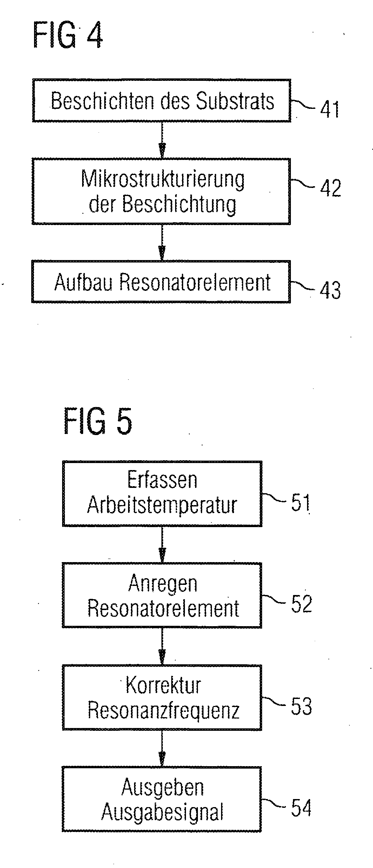

Im Folgenden unter Bezugnahme auf Figur 4 ein Ausführungsbeispiel eines Verfahrens zur Herstellung der erfindungsgemäßen Vorrichtung beschrieben.

In Schritt 41 wird ein Si-Wafer-Element, dessen Deckschicht aus Siliziumoxid (SiₓO_{y}/SiO2) besteht, mit einer Pt-Schicht durch Aufsputtern versehen.

In Schritt 42 wird durch Mikrostrukturierung eine Elektrode des piezoakustischen Resonators sowie ein Temperaturmesselement erstellt.

Die übrigen Schritte 43 zum Aufbau eines BAW Resonators sind grundsätzlich aus der Technik bekannt und bedürfen daher an dieser Stelle keiner detaillierten Erörterung. Beispielsweise kann durch rückseitige Ätzung eines Substrats eine Membran erstellt werden, auf der das Resonatorelement und die Temperaturerfassungseinrichtung angeordnet sind. Weitere Verfahrensschritte umfassen das Abscheiden einer piezoelektrischen Schicht, das Aufbringen der zweiten Elektrode sowie die entsprechende Kontaktierung der Elemente zur Erstellung der Vorrichtung.

Wie bereits erwähnt, ist es besonders vorteilhaft die untere oder die obere Elektrode sowie das Messelement durch Mikrostrukturierung derselben Pt-Schicht zu erstellen. Auf diese Weise ist es möglich nicht nur Elektrode bzw. Messelement aus einer Schicht zu erstellen, sondern beispielsweise auch zusätzlich ein Heizelement einer Heizeinrichtung. Bei einer besonders vorteilhaften Ausgestaltung können jedoch auch Elektrode, Heizelement und Messelement des Temperatursensors aus einem Schichtabschnitt gebildet werden, der je nach gewünschter Funktion unterschiedlich angesteuert wird.

Bezugnehmend auf Fig. 5 wird ein Ausführungsbeispiel eines Verfahrens zur Ausgabe eines Signals, das von einer Resonanzfrequenz abhängt, beschrieben.

In Schritt 51 wird eine Arbeitstemperatur einer Vorrichtung mit piezoakustischem Resonatorelement mit eine Temperaturerfassungseinrichtung erfasst.

In Schritt 52 wird durch Anlegen einer Wechselspannung an die Elektroden der piezoelektrischen Schicht des piezoakustischen Resonatorelements eine Dickenschwingung (d.h. Volumenschwingung) mit Resonanzfrequenz angeregt.

In Schritt 53 erfolgt eine Korrektur der gemessenen Resonanzfrequenz in Abhängigkeit der gemessenen Temperatur.

In Schritt 54 erfolgt das Ausgeben eines Ausgabesignals in Abhängigkeit des korrigierten Werts.

Besonders sinnvoll ist ein derartiges erfindungsgemäßes Verfahren, wenn es als Verfahren zur Detektion einer Substanz ausgestaltet ist. Hierbei umfasst es die zusätzlichen Schritte Zusammenbringen eines zur Sorption einer Substanz eingerichteten Oberflächenabschnitts des piezoakustischen Resonators mit einem Fluid, das die betreffende zu detektierende Substanz enthält. Nach Anlagerung der Substanz erfolgt die Messung der Resonanzfrequenz, die von der Masse der angelagerten Substanz abhängt. Es kann sich hierbei um eine differenzielle Messung, d.h. eine Messung der Resonanzfrequenz vor und nach Anlagerung der Substanz handeln. Aus der gemessenen Resonanzfrequenz kann auf die Anlagerung der betreffenden Substanz in dem Fluid rückgeschlossen werden. Durch Erfassung der Arbeitstemperatur der Vorrichtung kann die Bestimmung einer selektiven Anlagerung einer bestimmten Substanz erfolgen, die sich nur bei einer vorgegebenen Temperatur anlagert. Dieses Ausführungsbeispiel beinhaltet den Verfahrensschritt der Auswertung der gemessenen Resonanzfrequenz zur Detektion der betreffenden Substanz und Ausgabe eines betreffenden Ausgabewertes.

## Patentansprüche

1. Vorrichtung umfassend mindestens ein piezoakustisches Resonatoreleinent (2) mit einer piezoelektrischen Schicht (32) und zwei mit der piezoelektrischen Schicht (32) elektrisch kontaktierte Elektroden, wobei das piezoakustische Resonatorelement (2) derart beschaffen ist, dass durch Anlegen einer Spannung an die piezoelektrische Schicht (32) über die Elektroden eine akustische Dickenschwingung der piezoelektrischen Schicht (32) mit Resonanzfrequenz angeregt wird, wobei
eine integriert mit dem piezoakustischen Resonatorelement (2) ausgebildete Temperaturerfassungseinrichtung (3) vorhanden ist, die ein in Dünnschicht technik ausgebildetes Messelement
umfasst,
die Temperaturerfassungseinrichtung (3) und das piezoakustische Resonatorelement (2) in Dünnschich-technik auf einem gemeinsamen Trägersubstrat (35) ausgebildet sind und
eine Elektrode des Resonatorelements (2) und die Temperaturerfassungseinrichtung (3) als Schichten auf dem Trägersubstrat (35) angeordnet sind, wobei eine Schichtdicke der Temperaturerfassungseinrichtung < 25 µm beträgt und
die Vorrichtung als Sensorelement zur Detektion einer Substanz mit einem piezoakustischen Resonatorelement (2) ausgestaltet ist, wobei das piezoakustische Resonatorelement (2) einen Oberflächenabschnitt zur Sorption der Substanz aufweist und das Ausgangssignal des Reeonatorelementa (2) von der Anlagerung der Substanz abhängig ist, wobei zur Verstärkung des akustischen Signals zwischen dem
piezoakustischen Resonatorelement (31) und dem Trägersubstrat. (35) ein akustischer Spiegel (36) angeordnet ist,
sich die Temperaturerfassungseinrichtung (3) an einer solchen Position des Sensorelements befindet, dass sich die Temperaturerfassungseinrichtung (3) beim Messvorgang des Sensorelements in Kontakt mit einem Messmedium befindet, in dem sich die zu detektierende Substanz befindet, und dass das Messelement der Temperaturerfassungseinrichtung (3) auch als Heizelement der Heizeinrichtung betrieben werden kann, wobei
eine externe oder in der Vorrichtung integriert ausgebildete Auswerteeinrichtung (4) zur Ermittlung der Temperatur aus der Widerstandsänderung des Messelements in Abhängigkeit der Temperatur vorgesehen ist durch die die Gleichgewichtsbedingungen der Anlagerung der zu detektierenden Substanz an dem Oberflächenabschnitt der piezoakustischen Resonatorelements (2) durch Steuerung der Temperatur gezielt gesteuert werden.

2. Vorrichtung nach Anspruch 1, **dadurch gekennzeichnet, dass** das Trägersubstrat (35) aus einem Halbleitermaterial besteht.

3. Vorrichtung nach Anspruch 1 oder 2, **dadurch gekennzeichnet, dass** das Messelement als metallische Leiterbahn ausgebildet ist.

4. Vorrichtung nach einem der vorhergehenden Ansprüche, **dadurch gekennzeichnet, dass** das Messelement aus Platin besteht.

5. Vorrichtung nach einem der vorhergehenden Ansprüche, **dadurch gekennzeichnet, dass** zwischen dem Trägersubstrat (35) und dem piezoakustischen Resonatorelement (2) ein akustischer Spiegel (36) angeordnet ist, der aus mehreren Schichten besteht.

6. Vorrichtung nach einem der vorhergehenden Ansprüche, **dadurch gekennzeichnet, dass** der laterale Abstand zwischen dem Messelement und der piezoelektrischen Schicht (32) kleiner ist als 100 µm.

7. Vorrichtung nach einem der vorhergehenden Ansprüche, **dadurch gekennzeichnet, dass** das piezoakustische Resonatorelement (2) als Array ausgebildet ist, umfassend eine Mehrzahl piezoelektrischer Schichten (32) mit entsprechenden Elektroden und mindestens eine Temperaturerfassungseinrichtung (3).

8. Vorrichtung nach einem der vorhergehenden Ansprüche, **gekennzeichnet durch** eine integriert mit dem piezoakustischen Resonatorelement (2) ausgebildete Heizeinrichtung.

9. Vorrichtung nach einem der vorhergehenden Ansprüche, **gekennzeichnet durch** eine Korrektureinrichtung (8) zur Korrektur der Resonanzfrequenz des piezoakustischen Resonatorelements (2) anhand des von der Temperaturerfassungseinrichtung (3) erfassten Wertes.

10. Verwendung einer Vorrichtung gemä
- Anregen einer Volumenschwingung der piezoelektrischen Schicht (32) des piezoakustischen Resonatorelements (2) mit Resonanzfrequenz,
- Ausgeben eines Ausgabesignals in Abhängigkeit der gemessenen Arbeitstemperatur.

11. Verwendung nach Anspruch 10, **gekennzeichnet durch** den Schritt Ausgeben eines Ausgabewertes in der Abhängigkeit der gemessenen Resonanzfrequenz.

12. Verwendung nach Anspruch 10 oder 11, **dadurch gekennzeichnet, dass** die Verwendung als Verwendung zur Detektion einer Substanz ausgestaltet ist mit dem Schritt-Zusammenbringen eines zur Anlagerung einer Substanz eingerichteten Oberflächenabschnitts des piezoakustischen Resonators (31) mit einem Fluid, das die zu detektierende Substanz enthält, und
- Messen der Resonanzfrequenz in Abhängigkeit der Menge an angelagerter Substanz.

13. Verwendung nach einem der vorhergehenden Verwendungs-Ansprüche, **gekennzeichnet durch** den Schritt Steuern der Arbeitstemperatur des piezoakustischen Resonatorelements (2).

## Claims

1. Device comprising at least one piezoacoustic resonator element (2) having a piezoelectric layer (32) and two electrodes that are contacted electrically with the piezoelectric layer (32), whereby the piezoacoustic resonator element (2) is configured in such a manner that, when voltage is applied to the piezoelectric layer (32), a bulk acoustic wave of the piezoelectric layer (32) is induced with a resonance frequency by way of the electrodes,
with
a temperature measuring device (3) implemented to be integrated with the piezoacoustic resonator element (2) being present, which includes a measuring element implemented using thin film technology,
the temperature measuring device (3) and the piezoacoustic resonator element (2) being embodied using thin film technology (Fn) on a common carrier substrate (35) and an electrode of the resonator element (2) and the temperature measuring device (3) being arranged as layers on the carrier substrate (35), with
a layer thickness of the temperature measuring device amounting < 25µm and the device being configured as a sensor element for detecting a substance with a piezoacoustic resonator element (2), whereby the piezoacoustic resonator element (2) has a surface section for sorption of the substance and the output signal from the resonator element (2) is dependent on the sorption of the substance, with an acoustic mirror (36) being arranged between the piezoacoustic resonator element (31) and the carrier substrate (35), in order to amplify the acoustic signal,
the temperature measuring device (3) being positioned at such a position of the sensor element that the temperature measuring device (3) is in contact with a measuring medium during the measuring process of the sensor element, in which the substance to be detected is located, and that the measuring element, the temperature measuring device (3) and also the heating element of the heating facility can be operated, with an external evaluation device (4) or evaluation device implemented to be integrated in the device being provided to determine the temperature from the change in resistance of the measuring element as a function of the temperature, by means of which the balance conditions of the sorption of the substance to be detected on the surface section of the piezoacoustic resonator element (2) are targetedly controlled by controlling the temperature.

2. Device according to claim 1, **characterized in that** the carrier substrate (35) consists of a semiconductor material.

3. Device according to claim 1 or 2, **characterized in that** the measuring element is implemented as a metallic conductor.

4. Device according to one of the preceding claims, **characterized in that** the measuring element consists of platinum.

5. Device according to one of the preceding claims, **characterized in that** an acoustic mirror (36) comprising a plurality of layers is arranged between the carrier substrate (35) and the piezoacoustic resonator element (2).

6. Device according to one of the preceding claims, **characterized in that** the lateral gap between the measuring element and the piezoelectric layer (32) is less than 100 µm.

7. Device according to one of the preceding claims, **characterized in that** the piezoacoustic resonator element (2) is implemented as an array, comprising a plurality of piezoelectric layers (32) with corresponding electrodes and at least one temperature measuring device (3).

8. Device according to one of the preceding claims, **characterized by** a heating facility implemented so as to be integrated with the piezoacoustic resonator element (2).

9. Device according to one of the preceding claims, **characterized by** a correction facility (8) for correcting the resonance frequency of the piezoacoustic resonator element (2) on the basis of the value detected by the temperature measuring device (3).

10. Use of a device according to claim 1, for:
- exciting a volume oscillation of the piezoelectric layer (32) of the piezoacoustic resonator element (2) with resonance frequency,
- outputting an output signal as a function of the measured operating temperature.

11. Use according to claim 10, **characterized by** the step for outputting an output value as a function of the measured resonant frequency.

12. Use according to claim 10 or 11, **characterized in that** the use is configured as a use for the detection of a substance comprising the step:
- bringing together a surface section of the piezoacoustic resonator (31) set up for the sorption of a substance with a fluid which contains the substance to be detected, and
- measuring the resonance frequency as a function of the quantity of the accumulated substance.

13. Use according to one of the preceding use claims, **characterized by** the step of controlling the operating temperature of the piezoacoustic resonator element (2).

## Revendications

1. Dispositif comprenant au moins un élément résonateur piézoacoustique (2) avec une couche piézoélectrique (32) et deux électrodes en contact électrique avec la couche piézoélectrique (32), l'élément résonateur piézoacoustique (2) étant tel que l'application d'une tension à la couche piézoélectrique (32) via les électrodes provoque une vibration acoustique en épaisseur de la couche piézoélectrique (32) avec fréquence de résonance, un dispositif de détection de la température (3) réalisé de manière intégrée avec l'élément résonateur piézoacoustique (2) étant présent, lequel comprend un élément de mesure réalisé selon la technique des couches minces, le dispositif de détection de la température (3) et l'élément résonateur piézoacoustique (2) étant réalisés selon la technique des couches minces sur un substrat de support commun (35) et une électrode de l'élément résonateur (2) et le dispositif de détection de la température (3) étant disposés en tant que couches sur le substrat de support (35), une épaisseur de couche du dispositif de détection de la température étant < 25 µm et le dispositif se présentant sous la forme d'un élément capteur pour la détection d'une substance avec un élément résonateur piézoacoustique (2), l'élément résonateur piézoacoustique (2) présentant une partie de surface pour la sorption de la substance et le signal de sortie de l'élément résonateur (2) étant dépendant du dépôt de la substance, un miroir acoustique (36) étant disposé entre l'élément résonateur piézoacoustique (31) et le substrat de support (35) pour renforcer le signal acoustique, le dispositif de détection de la température (3) se trouvant à une position de l'élément capteur telle que le dispositif de détection de la température (3), à l'opération de mesure de l'élément capteur, est en contact avec un milieu de mesure dans lequel se trouve la substance à détecter et que l'élément de mesure du dispositif de détection de la température (3) peut également fonctionner en tant qu'élément de chauffage du dispositif de chauffage, un dispositif d'évaluation (4) externe ou réalisé de manière intégrée dans le dispositif, , étant prévu pour déterminer la température à partir de la modification de la résistance de l'élément de mesure en fonction de la température, dispositif d'évaluation par lequel les conditions d'équilibre du dépôt de la substance à détecter sur la partie de surface de l'élément résonateur piézoacoustique (2) sont réglées de manière ciblée par réglage de la température.

2. Dispositif selon la revendication 1, **caractérisé en ce que** le substrat de support (35) se compose d'un matériau semi-conducteur.

3. Dispositif selon la revendication 1 ou 2, **caractérisé en ce que** l'élément de mesure se présente sous la forme d'une piste conductrice métallique.

4. Dispositif selon l'une des revendications précédentes, **caractérisé en ce que** l'élément de mesure se compose de platine.

5. Dispositif selon l'une des revendications précédentes, **caractérisé en ce qu'**est situé, entre le substrat de support (35) et l'élément résonateur piézoacoustique (2), un miroir acoustique (36) qui se compose de plusieurs couches.

6. Dispositif selon l'une des revendications précédentes, **caractérisé en ce que** la distance latérale entre l'élément de mesure et la couche piézoélectrique (32) est inférieure à 100 µm.

7. Dispositif selon l'une des revendications précédentes, **caractérisé en ce que** l'élément résonateur piézoacoustique (2) se présente sous la forme d'une matrice, comprenant une pluralité de couches piézoélectriques (32) avec des électrodes correspondantes et au moins un dispositif de détection de la température (3).

8. Dispositif selon l'une des revendications précédentes, **caractérisé par** un dispositif de chauffage réalisé de manière intégrée avec l'élément résonateur piézoacoustique (2).

9. Dispositif selon l'une des revendications précédentes, **caractérisé par** un dispositif de correction (8) pour corriger la fréquence de résonance de l'élément résonateur piézoacoustique (2) à l'aide de la valeur détectée par le dispositif de détection de la température (3).

10. Utilisation d'un dispositif selon la revendication 1 pour
- provoquer une vibration en volume de la couche piézoélectrique (32) de l'élément résonateur piézoacoustique (2) avec fréquence de résonance,
- émettre un signal de sortie en fonction de la température de service mesurée.

11. Utilisation selon la revendication 10, **caractérisée par** l'étape d'émission d'une valeur de sortie en fonction de la fréquence de résonance mesurée.

12. Utilisation selon la revendication 10 ou 11, **caractérisée en ce que** l'utilisation est conçue en tant qu'utilisation pour détecter une substance avec l'étape de
- mise en contact d'une partie de la surface du résonateur piézoacoustique (31) aménagée pour la le dépôt d'une substance avec un fluide qui contient la substance à détecter et
- mesure de la fréquence de résonance en fonction de la quantité de substance déposée.

13. Utilisation selon l'une des revendications précédentes relatives à l'utilisation, **caractérisée par** l'étape de réglage de la température de service de l'élément résonateur piézoacoustique (2).
